# EUROPEAN PATENT APPLICATION

(11) **EP 3 163 500 A1**
(43) Date of publication of application: **03.05.2017**
(21) Application number: 16193747.9
(22) Date of filing: 13.10.2016
(51) Int. Cl.: G06K 9/00, G06K 9/20, G06K 9/46, G06K 9/62

(54) **METHOD AND DEVICE FOR IDENTIFYING REGION**

(30) Priority: 30.10.2015 CN 201510728282
(71) Applicant: Xiaomi Inc., Beijing 100085 (CN)
(72) Inventor: LONG, Fei, BEIJING, 100085 (CN); ZHANG, Tao, BEIJING, 100085 (CN); CHEN, Zhijun, BEIJING, 100085 (CN)
(74) Representative: Cougard, Jean-Marie

(57) **Abstract**

A method and a device for identifying regions are provided in the disclosure, which belong to the technical field of image processing. The method includes: obtaining (102) area position of face region in an identification image; determining (104) at least one information region based on the area position of face region; and segmenting (106) the information region to get at least one character region. It can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

## Description

### TECHNICAL FIELD

The present disclosure generally relates to image processing field, and more particularly to a method and a device for identifying regions.

### BACKGROUND

Automatic identification of an identity card is a technology for indentifying character information on the identity card by image processing.

The related technology provides a method for automatically identifying an identity card, the method comprising scanning the identity card by an identity card scanning device in a fixed relative location to obtain the scanned image of the identity card; identifying features of predefined *n* regions in the scanned image to obtain information about at least one of name, gender, nationality, date of birth, address and civil identity number. However, it is difficult to identify the image of the identity card obtained directly by photographing.

### SUMMARY

In view of the problems in related arts, a method and device for identifying regions are provided in the disclosure.

According to a first aspect of the present disclosure, a method for identifying face regions is provided. The method is implemented by a device (or terminal). The method includes: obtaining area position of face region in an identification image; determining at least one information region based on the area position of face region; and segmenting the information region to get at least one character region.

In an exemplary embodiment, the area position of face region is represented by using a predefined edge of the face region; wherein obtaining area position of face region in an identification image includes: identifying a face in the identification image to get the face region; and identifying the predefined edge of the face region based on the face region.

In an exemplary embodiment, identifying a face in the identification image to get the face region includes: identifying face in a predefined region of the identification image to get the face region through a face model having a predefined face size.

In an exemplary embodiment, identifying the predefined edge of the face region based on the face region includes: determining a region of interest based on the lower part of the face region, wherein the region of interest includes lower edge of the face region; and performing a straight line detection on the region of interest to identify the lower edge of the face region.

In an exemplary embodiment, performing a straight line detection on the region of interest to identify the lower edge of the face region includes: subjecting the region of interest to Sobel horizontal filter and binarization to obtain a processed region of interest; performing the straight line fitting or Hough transformation on the processed region of interest to get a line segment, of which the length is larger than a predefined length, and identify the line segment as the lower edge on the face region.

In an exemplary embodiment, the method further includes: correcting lean of the identification image based on slope of the predefined edge.

In an exemplary embodiment, correcting lean of the identification image based on slope of the predefined edge includes: determining an angle between the predefined edge and a horizontal direction based on the slope of the predefined edge; and rotating the identification image based on the angle so that the predefined edge of the rotated identification image is parallel to the horizontal direction.

In an exemplary embodiment, segmenting the information region to get at least one character region includes: binarizing the information region to get the binarized information region; calculating a first histogram for the binarized information region in the horizontal direction, wherein the first histogram includes vertical coordinate of the pixel points in each row and an accumulated value of the numbers of the pixel points of the foreground color in the pixel points in each row; identifying *n* rows of character regions based on the set of consecutive rows composed of the rows in which the accumulated value of the numbers of the pixel points of the foreground color in the first histogram is greater than a first threshold, wherein *n* is a positive integer; for the *i^{th}* row of character regions, calculating a second histogram for the binarized information region in the vertical direction, wherein the second histogram includes the horizontal coordinate of the pixel points in each column and an accumulated value of the numbers of the pixel points of the foreground color in the pixel points in each column, wherein *n* ≥ *i* ≥ 1 and *i* is a positive integer; identifying *nᵢ* character regions based on the set of consecutive columns composed of the columns in which the accumulated value of the numbers of the pixel points of the foreground color in the second histogram is greater than a second threshold.

A computer program is provided according to a particular aspect of the invention. The computer program performs the steps of a method as defined above when this program is executed by a computer. According to this particular aspect of the invention, the steps of the method as defined above are determined by computer program instructions.

This computer program can use any programming language and take the form of source code, object code or a code intermediate between source code and object code, such as a partially compiled form, or any other desirable form.

The invention is also directed to a computer-readable information medium containing instructions of the computer program as described above.

The information medium can be any entity or device capable of storing the program. For example, the support can include storage means such as a ROM, for example a CD ROM or a microelectronic circuit ROM, or magnetic storage means, for example a diskette (floppy disk) or a hard disk.

The information medium can also be an integrated circuit in which the program is incorporated, the circuit being adapted to execute the method in question or to be used in its execution.

According to a second aspect of the present disclosure, a device for identifying regions is provided. The device includes: an obtaining module configured to obtain area position of face region in an identification image; a determination module configured to determine at least one information region based on the area position of face region; and a segmentation module configured to segment the information region to get at least one character region.

In an exemplary embodiment, the area position of face region is represented by using a predefined edge of the face region; wherein the obtaining module includes a first identification sub-module configured to identify face in the identification image to get the face region; and a second identification sub-module configured to identify the predefined edge of the face region based on the face region.

In an exemplary embodiment, the first identification sub-module is configured to identify face in a predefined region of the identification image to get the face region through a face model having a predefined face size.

In an exemplary embodiment, the second identification sub-module includes: an interest determination sub-module configured to determine a region of interest based on the lower part of the face region, wherein the region of interest includes lower edge of the face region; and a detection sub-module configured to perform detection straight line detection on the region of interest to identify the lower edge of the face region.

In an exemplary embodiment, the detection sub-module includes: a filter sub-module configured to subject the region of interest to Sobel horizontal filter and binarization to obtain a processed region of interest; and a transformation sub-module configured to perform the straight line fitting or Hough transformation on the processed region of interest to get a line segment, of which the length is larger than a predefined length and identify the line segment as the lower edge on the face region.

In an exemplary embodiment, the device further includes: a correction module configured to correct lean of the identification image based on slope of the predefined edge.

In an exemplary embodiment, the correction module includes: an angle determination sub-module configured to determine an angle between the predefined edge and a horizontal direction based on the slope of the predefined edge; and a rotation sub-module configured to rotate the identification image based on the angle so that the predefined edge of the rotated identification image is parallel to the horizontal direction.

In an exemplary embodiment, the segmentation module includes: a binarization module configured to binarize the information region to get the binarized information region; a first calculation sub-module configured to calculate a first histogram of the binarized information region in the horizontal direction, wherein the first histogram includes vertical coordinate of the pixel points in each row and an accumulated value of the numbers of the pixel points of the foreground color in the pixel points in each row; a row identification sub-module configured to identify *n* rows of character regions based on the set of consecutive rows composed of the rows in which the accumulated value of the numbers of the pixel points of the foreground color in the first histogram is greater than a first threshold, wherein *n* is a positive integer; a second calculation sub-module configured to, for the *i^{th}* row of character regions, calculate a second histogram of the binarized information region in the vertical direction, wherein the second histogram includes the horizontal coordinate of the pixel points in each column and an accumulated value of the numbers of the pixel points of the foreground color in the pixel points in each column, wherein *n* ≥ *i* ≥ 1 and *i* is a positive integer; and a character identification sub-module configured to identify *nᵢ* character regions based on the set of consecutive columns composed of the columns in which the accumulated value of the numbers of the pixel points of the foreground color in the second histogram is greater than a second threshold.

According to a third aspect of the present disclosure, a device for identifying regions is provided. The device includes: a processor; a memory for storing instructions executable by the processor; wherein the processor is configured to: obtain area position of face region in an identification image; determine at least one information region based on the area position of face region; and segment the information region to get at least one character region.

Embodiments of the disclosure may provide at least some of the following beneficial effects: by obtaining area position of face region in an identification image; determining at least one information region based on the area position of face region; and segmenting the information region to get at least one character region, it can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

It is to be understood that both the forgoing general description and the following detailed description are exemplary only, and are not restrictive of the present disclosure.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a flow diagram illustrating a method for identifying regions according to an exemplary embodiment.
Fig. 2 is a flow diagram illustrating a method for identifying regions according to another exemplary embodiment.
Fig. 3A is a flow diagram illustrating a method for identifying regions according to another exemplary embodiment.
Fig. 3B is a schematic diagram illustrating face identification according to an exemplary embodiment.
Fig. 3C is a flow diagram illustrating a method for identifying regions according to an exemplary embodiment.
Fig. 3D is a schematic diagram illustrating the face image subjected to Sobel horizontal filter according to an exemplary embodiment.
Fig. 3E is a schematic diagram illustrating the binarized face image according to an exemplary embodiment.
Fig. 3F is a schematic diagram illustrating the face image on which the Hough transformation is performed according to an exemplary embodiment.
Fig. 4 is a flow diagram illustrating a method for identifying regions according to another exemplary embodiment.
Fig. 5A is a flow diagram illustrating a method for identifying regions according to another exemplary embodiment.
Fig. 5B is a schematic diagram illustrating a first histogram of the information region according to an exemplary embodiment.
Fig. 5C is a schematic diagram illustrating the set of consecutive rows of the information region according to an exemplary embodiment.
Fig. 5D is a schematic diagram illustrating a second histogram of the information region according to an exemplary embodiment.
Fig. 5E is a schematic diagram illustrating the set of consecutive columns of the information region according to an exemplary embodiment.
Fig. 6 is a block diagram illustrating a device for identifying regions according to an exemplary embodiment.
Fig. 7 is a block diagram illustrating a device for identifying regions according to another exemplary embodiment.
Fig. 8 is a block diagram illustrating a second identification sub-module in the device for identifying regions according to an exemplary embodiment.
Fig. 9 is a block diagram illustrating a device for identifying regions according to another exemplary embodiment.
Fig. 10 is a block diagram illustrating a device for identifying regions according to another exemplary embodiment.
Fig. 11 is a block diagram illustrating a device for identifying regions according to an exemplary embodiment.

### DETAILED DESCRIPTION

Reference will now be made in detail to exemplary embodiments, examples of which are illustrated in the accompanying drawings. The following description refers to the accompanying drawings in which same numbers in different drawings represent same or similar elements unless otherwise described. The implementations set forth in the following description of exemplary embodiments do not represent all implementations consistent with the disclosure. Instead, they are merely examples of devices and methods consistent with aspects related to the disclosure as recited in the appended claims.

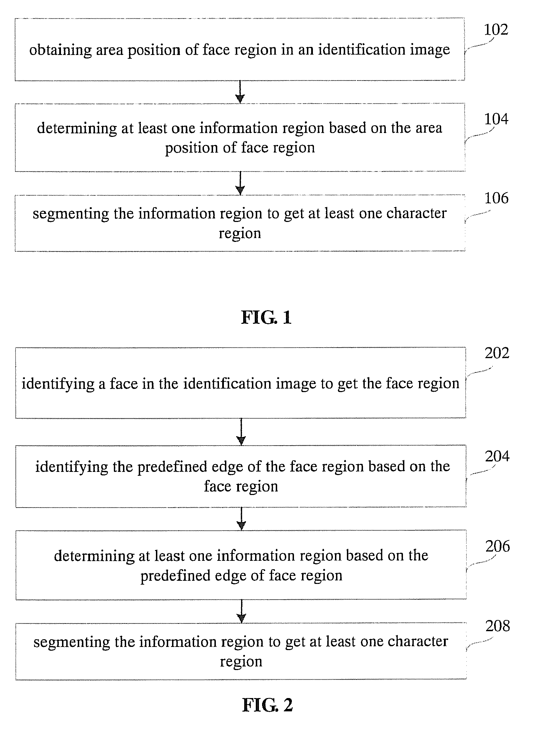

Fig. 1 is a flow diagram illustrating a method for identifying face regions according to an exemplary embodiment. The method may be implemented by a terminal (or device). As illustrated in Fig. 1, the method for identifying regions may include the following steps.

In step 102, an area position of a face region in an identification image is obtained (or detected). In a particular example, a predefined edge is identified in the identification image.

The identification image is the image obtained directly by photographing an identification document, such as an image of an identity card, an image of a social security card and the like.

Since the identification document usually contains a user's ID photo, the identification image would have a face region.

In step 104, at least one information region is determined (or detected) based on the area position of the face region. The at least one information region may include picture element information relative to the face region.

Since the location of the face region in the identification is relatively fixed, and the locating of the face region is easier than that of the information regions, each information region can be identified in the identification image based on the area position of the face region.

The information region refers to a region carrying character information in the identification image, such as at least one of name information region, date of birth information region, gender information region, address information region, civil identity number information region, serial number information region, issuance office of the identification information region, valid date information region and the like.

Character information may refer to identification information (such as civil data) identifying an individual associated with the identity document.

In step 106, the information region is segmented to get at least one character region.

The information region may include a plurality of characters. At least one character region can be obtained by segmenting one information region. The character region is a region containing a single character. The character may be Chinese character, English letter, numeral and a single character of any other language.

In summary, in the method for identifying regions according to the embodiment of the disclosure, by obtaining area position of face region in an identification image; determining at least one information region based on the area position of face region; and segmenting the information region to get at least one character region, it can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

Fig. 2 is a flow diagram illustrating a method for identifying regions according to another exemplary embodiment. The method is implemented by a terminal (or device). As illustrated in Fig. 2, the method for region identification may include the following steps.

In step 202, a face is identified in the identification image to get the face region.

In a particular example, when photographing an identification document, there is a rectangular region in a photographing interface for guiding the photographing. A user can photograph the identification document by aligning the rectangular region to the identification document so as to obtain the identification image.

Since the identification document usually contains a user's ID photo, the identification image would have a face region. The face region may be identified in the identification image through face recognition technology. The face recognition technology is a mature recognition technology. The embodiment does not limit what kind of face recognition technology is used.

In step 204, a predefined edge of the face region is identified based on the face region.

In a particular example, the predefined edge is a lower edge of the face region.

In the identification image, since the lower edge of the face region has significant difference from background color of the identification, the lower edge of the face region is an edge which is relative easily identified.

In step 206, at least one information region is determined (or detected) based on the predefined edge of the face region.

When the type of the identification image is known (or when the type of the identification document is known), a position relationship between the predefined edge of the face region and the other information region of the identification is fixed, therefore, at least one information region can be determined based on the predefined edge of the face region and the relative position relationship.

For instance, taking the second-generation identity card as an example, the civil identity number region is located below the lower edge of the face region; for another instance, the address information region is located at left side of the face region in horizontal direction and located between the lower edge of the face region and a half-height of the face region in vertical direction. At least one information region can be determined can be determined based on the predefined edge of the face region and the relative position relationship.

In step 208, the information region is segmented to get at least one character region.

The information region may include a plurality of characters. At least one character region can be obtained by segmenting one information region. The character region is a region containing a single character. The character may be Chinese character, English letter, numeral and a single character of other language

In summary, in the method for identifying regions according to the embodiment of the disclosure, by obtaining a predefined edge of face region in an identification image; determining information region based on the predefined edge of the face region; and segmenting the information region to get at least one character region, it can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

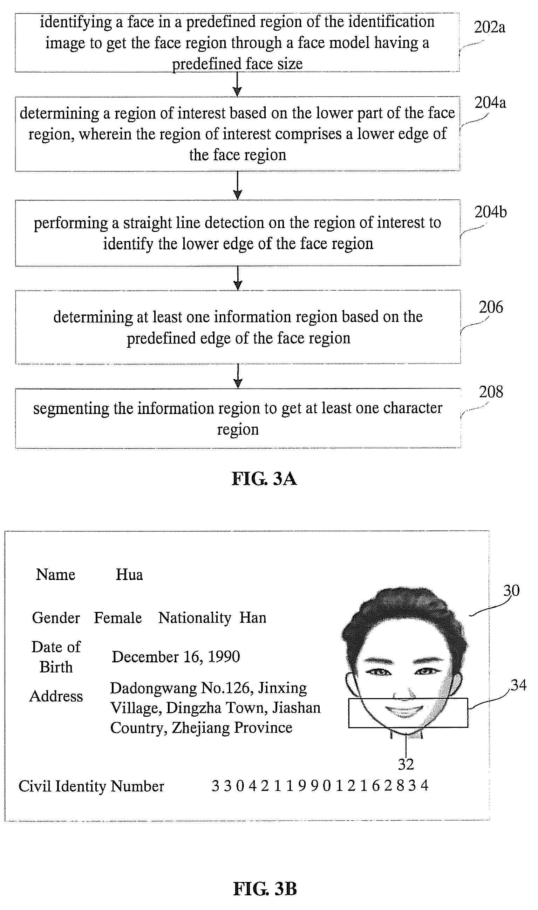

In an exemplary embodiment, based on the embodiment as shown in Fig. 2, the above step 202 may be implemented as step 202a, the above step 204 may be implemented as step 204a and 204b, as shown in Fig. 3A.

In step 202a, a face is identified in a predefined region of the identification image to get the face region through a face model having a predefined face size.

In a particular example, a pre-training is performed to obtain a face model. Since a size of the face region in the identification image is relatively fixed, the face model is a face model having a predefined face size.

The terminal identifies a face in the predefined region of the identification image to get the face region through the face model having the predefined face size. In a particular example, the identification image is segmented into a plurality of window regions, and the image characteristic of each window region is extracted and inputted into the face model. When the face model outputs a positive result, the corresponding window region is identified as a face region; when the face model outputs a negative result, the corresponding window region is identified as a non-face region.

In a particular example, since the face region is usually located at upper right of the identification document, face identification is performed on a predefined region located on the right of the identification image when identifying the face.

The embodiment does not strictly limit the accuracy of the identified face region.

In step 204a, a region of interest is determined based on the lower part of the face region, wherein the region of interest includes lower edge of the face region.

The region of interest is determined at the lower part of the face region based on a preset window so that the region of interest covers the lower edge of the face region.

For example, as shown in Fig. 3B, after identifying the face region 30, a region of interest 34 is selected from the identification image by taking the center 32 of the lower part of the face region 30 as a center and taking the size of the preset window as a range.

In step 204b, a straight line detection is performed on the region of interest to identify the lower edge of the face region.

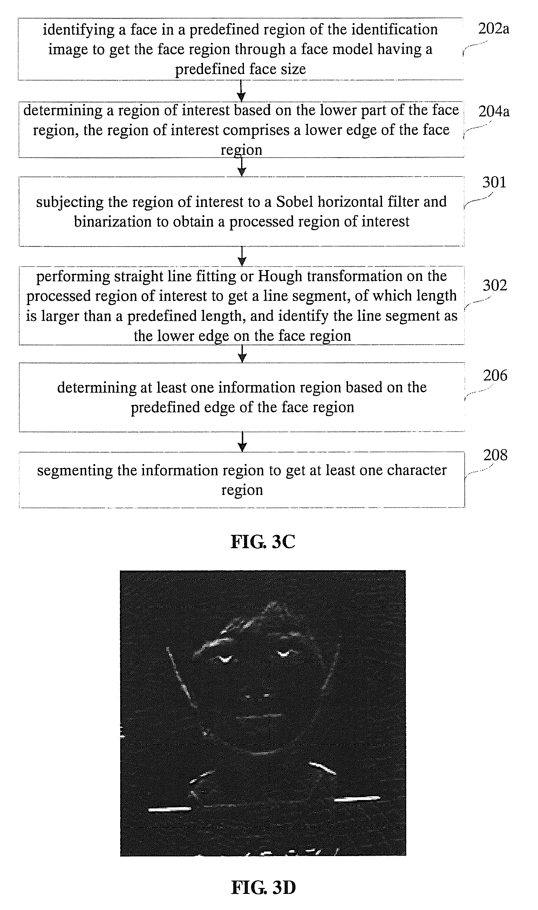

Alternatively, the straight line detection method uses a straight line fitting algorithm or Hough transformation algorithm. The step 204b may be alternatively implemented as step 301 and step 302, as shown in Fig. 3C.

In step 301, the region of interest is subjected to Sobel horizontal filter and binarization to obtain the processed region of interest.

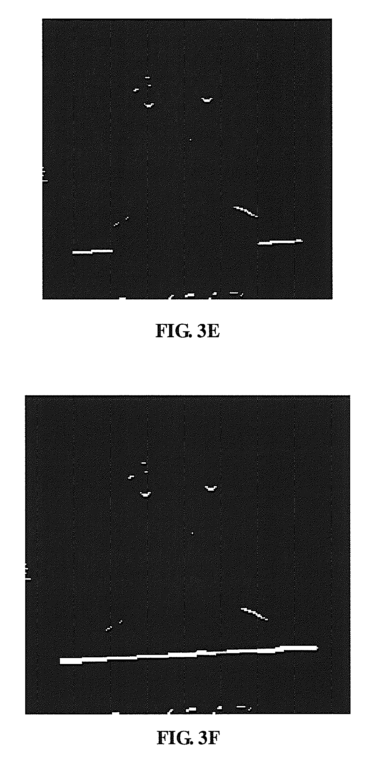

Firstly, the region of interest is subjected to Sobel, that is to say, the region of interest is filtered with a Sobel operator in horizontal direction, and the effect diagram is shown in Fig. 3D. Then, the filtered region of interest is binarized. The binarization refers to comparing the gray values of the pixel points in the region of interest with a predefined gray threshold and dividing the pixel points in the region of interest into two groups: a group of pixel points whose gray values are greater than the predefined gray threshold and a group of pixel points whose gray values are less than the predefined gray threshold. The two groups of pixel points are presented with two different colors of black and white in the identification image, thus obtaining the binarized region of interest, as shown in Fig. 3E. The pixel points located in the color of foreground are referred as the pixel points of foreground color, i.e., the white pixel points of Fig. 3E, and the pixel points located in the color of background are referred as the pixel points of background color, i.e., the black pixel points of Fig. 3E.

In step 302, the straight line fitting or Hough transformation is conducted for the processed region of interest to get a line segment, of which the length is larger than a predefined length, and identify the line segment as the lower edge on the face region.

As shown in Fig. 3F, after performing Hough transformation, there is a line segment, of which the length is larger than a predefined length, located below the face region, and the line segment is the lower edge of the face region.

In summary, in the method for region identification according to the embodiment of the disclosure, by determining the region of interest based on the lower part of the face region, subjecting the region of interest to Sobel horizontal filter and binarization to obtain a processed region of interest; conducting the straight line fitting or Hough transformation for the processed region of interest to obtain a line segment, of which the length is larger than a predefined length; identifying the line segment as the lower edge of the face region, it can effectively and accurately identify the lower edge of the face region. Meanwhile, since he region of interest has a small range, it would have small calculating amount when extracting the lower edge, and therefore, it can improve the identification speed.

For the above step 202a, it needs to be pre-trained to get the face model. For example, the training procedure includes the following steps.

A positive sample image and a negative sample image are pre-obtained. The positive sample image may include a face region having a predefined size. The negative sample image may include an image of region having no face, an image of region containing incomplete face, an image of the face region not having a predefined size, and an image of busy background, and so on.

Image characteristics of the positive sample image and image characteristics of the negative sample image are extracted, such as hair characteristic. Then, the image characteristic of the positive sample image and a first tag representing the positive result are inputted into an initial model, and the image characteristic of the negative sample image and a second tag representing the negative result are inputted into an initial model, and a face model is obtained after training. Alternatively, the first tag is "1" and the second tag is "0". The initial model is constructed through sorting algorithm, such as Adaboost or Support Vector Machine (SVM).

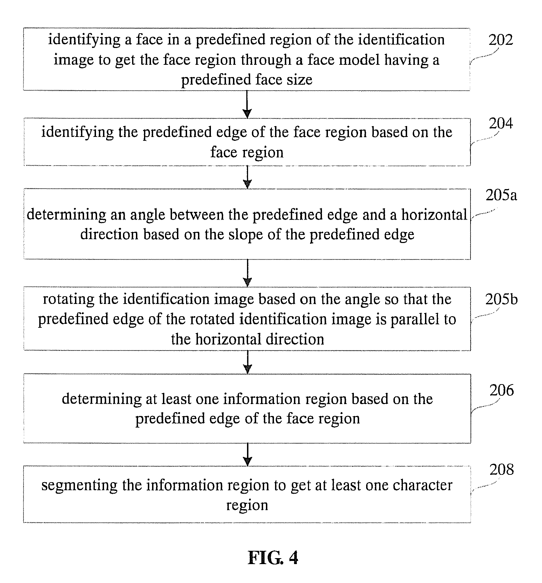

In an exemplary embodiment, based on the embodiment as shown in Fig. 2, the identification document has a small angle rotation with respect to the horizontal direction in the identification image; that is, the identification document is not horizontal in the identification image, but has an angle with the horizontal direction. In a particular example, the terminal corrects lean of the identification image based on slope of the predefined edge. That is, after the step 204, the method may further include steps 205a and 205b, as shown in Fig. 4.

In step 205a, an angle between the predefined edge and the horizontal direction is determined based on the slope of the predefined edge.

The terminal calculates an angle between the lower edge of the face region and the horizontal direction. The angle also is an angle between the identification document and the horizontal direction.

In step 205b, the identification image is rotated based on the angle so that the predefined edge of the rotated identification image is parallel to the horizontal direction.

In summary, in the method for region identification according to the embodiment, by rotating the predefined edge of the face region to make correction so that the identification of the identification image is parallel to the horizontal direction, it can improve an accuracy of subsequently identifying the information region.

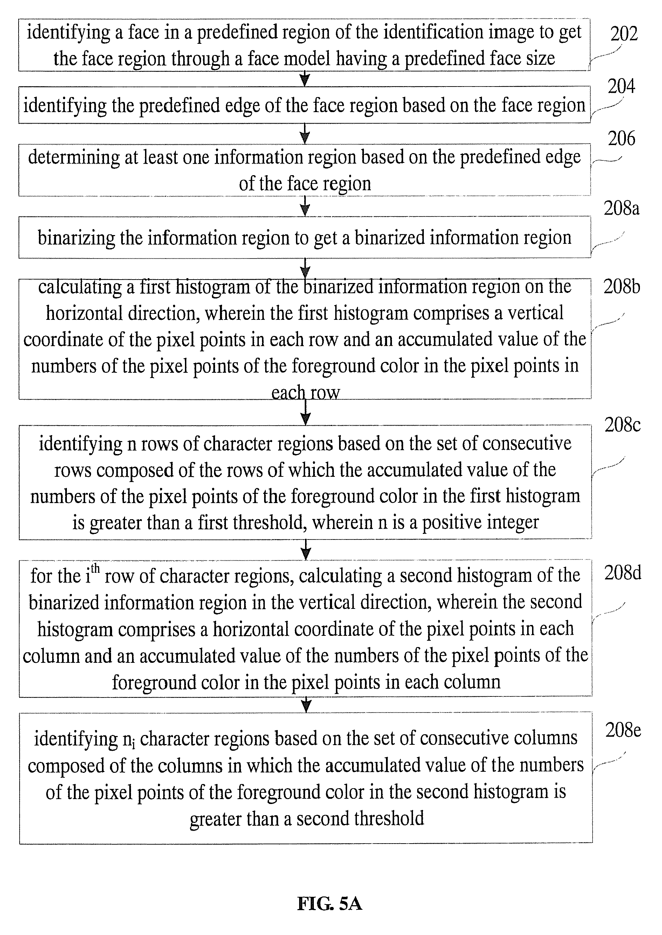

In an exemplary embodiment, based on the embodiment as shown in Fig. 2, step 208 is a procedure of segmenting the information region. In a particular example, the step 208 can be implemented as the following steps 208a-208e, as shown in Fig. 5A.

In step 208a, the information region is binarized to obtain the binarized information region.

Assuming for instance that the information region is a civil identity number region, the information region may be firstly pre-processed. The pre-processing may include operations such as de-noising, filtering, extracting edges and so on. The pre-processed information region may be binarized.

In step 208b, a first histogram of the binarized information region is calculated on horizontal direction, wherein the first histogram includes the vertical coordinate of the pixel points in each row and an accumulated value of the number of the pixel points of the foreground color in the pixel points in each row.

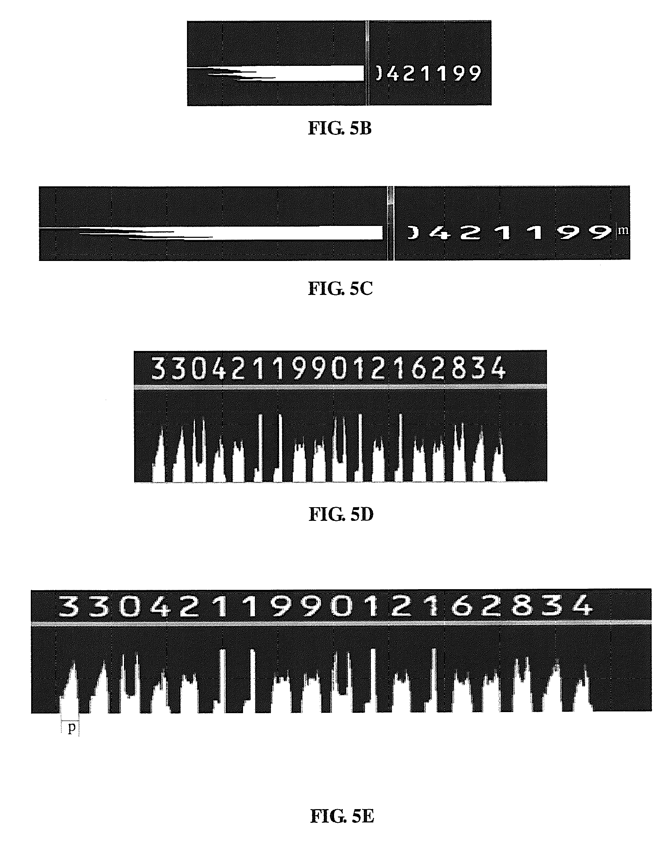

The first histogram of the binarized information region is calculated on horizontal direction, wherein the first histogram represents the vertical coordinate of the pixel points in each row in the vertical direction and an accumulated value of the number of the pixel points of the foreground color in the pixel points in each row in the horizontal direction, as shown in Fig. 5B.

In step 208c, *n* rows of character regions are identified based on the set of consecutive rows composed of the rows in which the accumulated value of the numbers of the pixel points of the foreground color in the first histogram is greater than a first threshold, wherein *n* is a positive integer.

The accumulated value of the numbers of the pixel points of the foreground color in the pixel points in each row can be obtained based on the first histogram. By comparing the accumulated value of the numbers of the pixel points of the foreground color in the pixel points in each row with the first threshold, the set of consecutive rows composed of the rows in which the accumulated value of the numbers of the pixel points of the foreground color in the first histogram is greater than the first threshold can be determined as the rows in which the character regions are located.

The set of consecutive rows refers to the set of m consecutive rows of pixel points of which the accumulated value of the numbers of the pixel points of the foreground color is greater than the first threshold, as shown in Fig. 5C. For the m rows of pixel points in Fig. 5C, the accumulated value of the numbers of the pixel points of the foreground color in the left histogram is greater than the first threshold. The m rows of pixel points correspond to the row of civil identity number "0421299" in the identification image.

When the information region is the address information region or other information regions, the character region may contain two or more rows. Meanwhile, each set of consecutive rows is identified as a row of character regions and *n sets* of consecutive rows are identified as *n* rows of character regions.

In step 208d, for the *i^{th}* row of character regions, a second histogram is calculated on vertical direction, wherein the second histogram includes the horizontal coordinate of the pixel points in each column and an accumulated value of the number of the pixel points of the foreground color in the pixel points in each column, wherein *n* ≥ *i ≥* 1 and *i* is a positive integer.

For the identified row of the civil identity number, the second histogram is calculated on vertical direction, wherein the second histogram represents the horizontal coordinate of the pixel points in each column on horizontal direction, and the accumulated value of the numbers of the pixel points of the foreground color in the pixel points in each column on vertical direction, as shown in Fig. 5D.

In step 208e, *nᵢ* character regions are identified based on the set of consecutive columns composed of the columns in which the accumulated value of the numbers of the pixel points of the foreground color in the second histogram is greater than a second threshold.

The accumulated value of the numbers of the pixel points of the foreground color in the pixel points in each column can be obtained based on the second histogram. By comparing the accumulated value of the numbers of the pixel points of the foreground color in the pixel points in each column with the second threshold, the set of consecutive columns composed of the columns in which the accumulated value of the numbers of the pixel points of the foreground color in the second histogram is greater than the second threshold can be determined as the column in which the character regions are located.

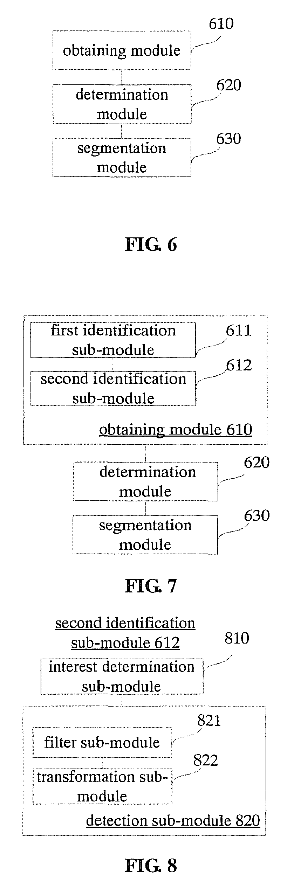

The set of consecutive columns refers to the set of p consecutive columns of pixel points of which the accumulated value of the numbers of the pixel points of the foreground color is greater than the second threshold. As shown in Fig. 5E, the set of consecutive columns is represented by "p", i.e., the consecutive white region formed in the second histogram. For the p consecutive columns of pixel points in Fig. 6E, the accumulated value of the numbers of the pixel points of the foreground color in the lower histogram is greater than the second threshold. The p consecutive columns of pixel points correspond to the character region "3" in the identification image.

Each set of consecutive columns is identified as one character region and *n* sets of consecutive columns are identified as *n* character regions. In Fig. 5E, 18character regions can be identified.

When there are *n* rows of character regions, the steps 208d and 208e are performed one time for each row of character regions, thus being performed totally *n* times.

For each identified character region, the characters contained in the character region can be identified through character identification technology. The characters may be Chinese characters, English letters, numbers and single character of other language.

In summary, in the method for region identification according to the embodiment of the disclosure, by binarizing the information region; calculating a first histogram of the binarized information region on horizontal direction; determining *n* rows of character regions in the information region; calculating a second histogram of the *n* rows of character regions on vertical direction; and identifying the character region to which each character corresponds, the accuracy of identifying the character regions in the information region can be improved.

The following are the device embodiments of the disclosure which may be used to perform the method embodiments of the disclosure. For the details not disclosed in the device embodiments, please see the method embodiments of the disclosure.

Fig. 6 is a block diagram illustrating a device (or terminal) for identifying regions according to an exemplary embodiment. As shown in Fig. 6, the device for identifying regions may include but not limited to an obtaining module 610, a determination module 620 and a segmentation module 630.

The obtaining module 610 is configured to obtain area position of face region in an identification image. The identification image is the image obtained directly by photographing an identification document, such as an image of an identity card, an image of a social security card and the like. Since the identification document usually contains a user's ID photo, the identification image would have a face region. The obtaining module 610 obtains area position of face region in the identification image.

The determination module 620 is configured to determine at least one information region based on the area position of face region. The information region refers to the region carrying character information in the identification image, such as at least one of name information region, date of birth information region, gender information region, address information region, civil identity number information region, serial number information region, issuance office of the identification information region, valid date information region and the like.

The determination module 620 is configured to determine at least one information region based on the area position obtained by the obtaining module 610.

The segmentation module 630 is configured to segment the information region to get at least one character region.

The information region may include a plurality of characters. At least one character region can be obtained by segmenting one information region. The character region is a region containing a single character. The character may be Chinese character, English letter, numeral and a single character of other language.

In summary, in the device for identifying regions according to the embodiment of the disclosure, by obtaining area position of face region in an identification image; determining at least one information region based on the area position of face region; and segmenting the information region to get at least one character region, it can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

Fig. 7 is a block diagram illustrating a device for identifying regions according to another exemplary embodiment. As shown in Fig. 7, the device for identifying regions may include but not limited to the obtaining module 610, the determination module 620 and the segmentation module 630.

The obtaining module 610 is configured to obtain area position of face region in an identification image.

The obtaining module 610 may include a first identification sub-module 611 and a second identification sub-module 612.

The first identification sub-module 611 is configured to identify a face in the identification image to get the face region. Since the identification document usually contains a user's ID photo, the identification image would have a face region. The face region may be identified in the identification image through face recognition technology. In the present embodiment, the module for identifying face region is the first identification sub-module 611.

The second identification sub-module 612 is configured to identify the predefined edge of the face region based on the face region. In the identification image, since the lower edge of the face region has significant difference from background color of the identification document, the lower edge of the face region is an edge which is relative easily identified. The second identification sub-module 612 identifies the predefined edge of the face region based on the face region.

The first identification sub-module 611 is further configured to identify a face in a predefined region of the identification image to get the face region through a face model having a predefined face size.

The determination module 620 is configured to determine at least one information region based on the area position of face region. When the type of the identification image is known, a relative position relationship between the predefined edge of the face region and the other information region of the identification document is fixed, and the determination module 620 determines at least one information region based on the predefined edge of the face region and the relative position relationship.

The segmentation module 630 is configured to segment the information region to get at least one character region.

The information region may include a plurality of characters. The segmentation module 630 segments one information region to get at least one character region. The character region is a region containing a single character. The character may be Chinese character, English letter, numeral and a single character of other language

In summary, in the device for identifying regions according to the embodiment of the disclosure, by obtaining a predefined edge of face region in an identification image; determining information region based on the predefined edge of the face region; and segmenting the information region to get at least one character region, it can solve the problems in related art that it is difficult to identify some information regions in the identification image obtained directly by photographing and that the locating of some information regions are inaccurate, and it can achieve the effects of locating the information regions accurately and identifying the character region in the information region accurately by determining the other information regions through the area position of face region in the identification image and segmenting the other information regions.

In an exemplary embodiment, based on the embodiment as shown in Fig. 7, the second identification sub-module 612 may includes an interest determination sub-module 810 and a detection sub-module 820, as shown in Fig. 8.

The interest determination sub-module 810 is configured to determine a region of interest based on the lower part of the face region, wherein the region of interest includes lower edge of the face region. The interest determination sub-module 810 determines the region of interest at the lower part of the face region based on a preset window so that the region of interest covers the lower edge of the face region.

The detection sub-module 820 is configured to perform detection straight line detection on the region of interest to identify the lower edge of the face region.

Alternatively, the straight line detection method may use a straight line fitting algorithm or Hough transformation algorithm.

The detection sub-module may include a filter sub-module 821 and a transformation sub-module 820.

The filter sub-module 821 is configured to subject the region of interest to Sobel horizontal filter and binarization to obtain a processed region of interest. Firstly, the filter sub-module 821 filters the region of interest horizontally by Sobel, that is to say, filters the region of interest with a Sobel operator on horizontal direction, and then binarizes the filtered region of interest.

The binarization refers to comparing the gray values of the pixel points in the region of interest with a predefined gray threshold and dividing the pixel points in the region of interest into two groups: a group of pixel points whose gray values are greater than the predefined gray threshold and a group of pixel points whose gray values are less than the predefined gray threshold. The two groups of pixel points are presented with two different colors of black and white in the identification image, thus obtaining the binarized region of interest.

The transformation sub-module 822 is configured to perform the straight line fitting or Hough transformation on the processed region of interest to get a line segment, of which length is larger than a predefined length, and identify the line segment as the lower edge on the face region.

In summary, in the device for region identification according to the embodiment of the disclosure, by determining the region of interest based on the lower part of the face region, subjecting the region of interest to Sobel horizontal filter and binarization to obtain a processed region of interest; conducting the straight line fitting or Hough transformation for the processed region of interest to obtain a line segment, of which length is larger than a predefined length; identifying the line segment as the lower edge of the face region, it can effectively and accurately identify the lower edge of the face region. Meanwhile, since he region of interest has a small range, it would have small calculating amount when extracting the lower edge, and therefore, it can improve the identification speed.

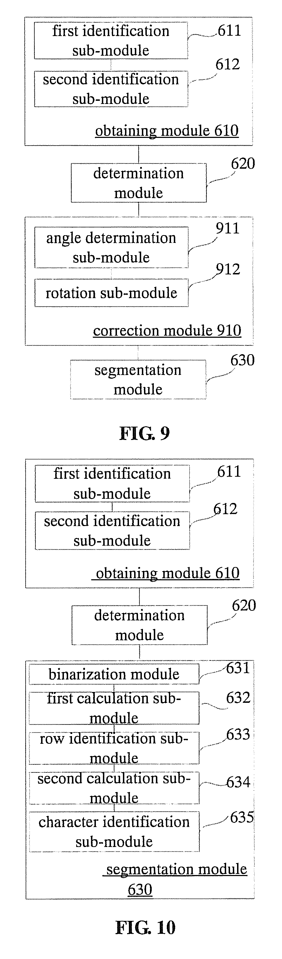

In an exemplary embodiment, based on the embodiment as shown in Fig. 7, the device for identifying regions may further include a correction module 910 configured to correct lean of the identification image based on slope of the predefined edge, as shown in Fig. 9.

The correction module 910 may includes an angle determination sub-module 911 and a rotation sub-module 912.

The angle determination sub-module 911 is configured to determine an angle between the predefined edge and a horizontal direction based on the slope of the predefined edge. The angle determination sub-module 911 in a terminal may calculate an angle between the lower edge of the face region and the horizontal direction, wherein the angle also is an angle between the identification document and the horizontal direction.

The rotation sub-module 912 is configured to rotate the identification image based on the angle so that the predefined edge of the rotated identification image is parallel to the horizontal direction.

The rotation sub-module 912 rotates the identification image based on the angle calculated by the angle determination sub-module 911 in the terminal.

In summary, in the device for region identification according to the embodiment, by rotating the predefined edge of the face region to make correction so that the identification of the identification image is parallel to the horizontal direction, it can improve an accuracy of subsequently identifying the information region.

In an exemplary embodiment, based on the embodiment as shown in Fig. 7, the segmentation module 630 may include a binarization module 631, a first calculation sub-module 632, a row identification sub-module 633, a second calculation sub-module 634 and a character identification sub-module 635, as shown in Fig. 10.

The binarization module 631 is configured to binarize the information region to get the binarized information region. Taking the information region being the civil identity number region as an example, alternatively, the binarization module 631 may firstly pre-process the information region, wherein the pre-processing may include operations such as de-noising, filtering, extracting edges and so on, and then binarize the pre-processed information region.

The first calculation sub-module 632 is configured to calculate a first histogram of the binarized information region in the horizontal direction, wherein the first histogram includes vertical coordinate of the pixel points in each row and an accumulated value of the numbers of the pixel points of the foreground color in the pixel points in each row.

The row identification sub-module 633 is configured to identify *n* rows of character regions based on the set of consecutive rows composed of the rows in which the accumulated value of the numbers of the pixel points of the foreground color in the first histogram is greater than a first threshold, wherein *n* is a positive integer. The accumulated value of the numbers of the pixel points of the foreground color in the pixel points in each row can be obtained based on the first histogram, the row identification sub-module 633 compares the accumulated value of the numbers of the pixel points of the foreground color in the pixel points in each row with the first threshold, and determine the set of consecutive rows composed of the rows in which the accumulated value of the numbers of the pixel points of the foreground color in the first histogram is greater than the first threshold as the rows in which the character regions are located.

The set of consecutive rows refers to the set of *m* consecutive rows of pixel points of which the accumulated value of the numbers of the pixel points of the foreground color is greater than the first threshold. Each set of consecutive rows is identified as a row of character regions and *n* sets of consecutive rows are identified as *n* rows of character regions.

The second calculation sub-module 634 is configured to, for the *i*^{th} row of character regions, calculate a second histogram of the binarized information region in the vertical direction, wherein the second histogram includes the horizontal coordinate of the pixel points in each column and an accumulated value of the numbers of the pixel points of the foreground color in the pixel points in each column, wherein *n ≥ i ≥* 1 and *i* is a positive integer. For the row of the civil identity number identified by the row identification sub-module 633, the second calculation sub-module 634 calculates the second histogram on vertical direction, wherein the second histogram represents the horizontal coordinate of the pixel points in each column on horizontal direction, and the accumulated value of the numbers of the pixel points of the foreground color in the pixel points in each column on vertical direction.

The character identification sub-module 635 is configured to identify *nᵢ* character regions based on the set of consecutive columns composed of the columns in which the accumulated value of the numbers of the pixel points of the foreground color in the second histogram is greater than a second threshold.

The accumulated value of the numbers of the pixel points of the foreground color in the pixel points in each column can be obtained based on the second histogram, the character identification sub-module 635 compares the accumulated value of the numbers of the pixel points of the foreground color in the pixel points in each column with the second threshold, and determines the set of consecutive columns composed of the columns in which the accumulated value of the numbers of the pixel points of the foreground color in the second histogram is greater than the second threshold as the column in which the character regions are located.

The set of consecutive columns refers to the set of p consecutive columns of pixel points of which the accumulated value of the numbers of the pixel points of the foreground color is greater than the second threshold. Each set of consecutive columns is identified as one character region and *n* sets of consecutive columns are identified as *n* character regions.

In summary, in the device for region identification according to the embodiment of the disclosure, by binarizing the information region, calculating a first histogram of the binarized information region on horizontal direction, determining *n* rows of character regions in the information region, calculating a second histogram of the *n* rows of character regions on vertical direction, and identifying the character region to which each character corresponds, the accuracy of identifying the character regions in the information region can be improved.

The disclosure further provides a device for identifying regions. The device may include: a processor; a memory for storing instructions executable by the processor; wherein the processor is configured to: obtain area position of face region in an identification image; determine at least one information region based on the area position of face region; and segment the information region to get at least one character region.

With respect to the device in the above embodiments, the specific manners that the respective modules perform operations have been described in detail in the embodiments regarding the relevant methods, and will not be repeated herein.

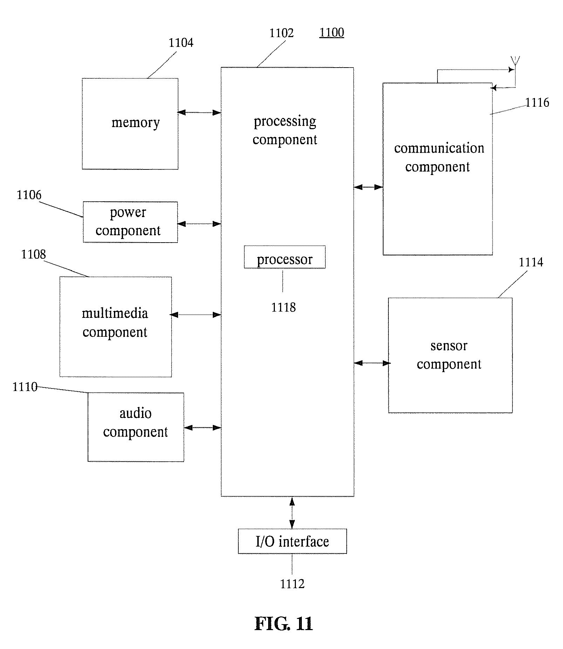

Fig. 11 is a block diagram of a device for identifying regions according to an exemplary embodiment. For example, the device 1100 may be a mobile phone, a computer, a digital broadcast terminal, a messaging device, a gaming console, a tablet, a medical device, exercise equipment, a personal digital assistant, and the like.

Referring to Fig. 11, the device 1100 may include one or more of the following components: a processing component 1102, a memory 1104, a power component 1106, a multimedia component 1108, an audio component 1110, an input/output (I/O) interface 1112, a sensor component 1114 and a communication component 1116.

The processing component 1102 typically controls overall operations of the device 1100, such as the operations associated with display, telephone calls, data communications, camera operations, and recording operations. The processing component 1102 may include one or more processors 1118 to execute instructions to perform all or part of the steps in the above described methods. Moreover, the processing component 1102 may include one or more modules which facilitate the interaction between the processing component 1102 and other components. For instance, the processing component 1102 may include a multimedia module to facilitate the interaction between the multimedia component 1108 and the processing component 1102.

The memory 1104 is configured to store various types of data to support the operation of the device 1100. Examples of such data include instructions for any applications or methods operated on the device 1100, contact data, phonebook data, messages, pictures, video, etc. The memory 1104 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1106 provides power to various components of the device 1100. The power component 1106 may include a power management system, one or more power sources, and any other components associated with the generation, management, and distribution of power for the device 1100.

The multimedia component 1108 includes a screen providing an output interface between the device 1100 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1108 includes a front camera and/or a rear camera. The front camera and the rear camera may receive an external multimedia datum while the device 1100 is in an operation mode, such as a photographing mode or a video mode. Each of the front camera and the rear camera may be a fixed optical lens system or have optical focusing and zooming capability.

The audio component 1110 is configured to output and/or input audio signals. For example, the audio component 1110 includes a microphone ("MIC") configured to receive an external audio signal when the device 1100 is in an operation mode, such as a call mode, a recording mode, and a voice recognition mode. The received audio signal may be further stored in the memory 1104 or transmitted via the communication component 1116. In some embodiments, the audio component 1110 further includes a speaker to output audio signals.

The I/O interface 1112 provides an interface between the processing component 1102 and peripheral interface modules, the peripheral interface modules being, for example, a keyboard, a click wheel, buttons, and the like. The buttons may include, but are not limited to, a home button, a volume button, a starting button, and a locking button.

The sensor component 1114 includes one or more sensors to provide status assessments of various aspects of the device 1100. For instance, the sensor component 1114 may detect an open/closed status of the device 1100, relative positioning of components (e.g., the display and the keypad, of the device 1100), a change in position of the device 1100 or a component of the device 1100, a presence or absence of user contact with the device 1100, an orientation or an acceleration/deceleration of the device 1100, and a change in temperature of the device 1100. The sensor component 1114 may include a proximity sensor configured to detect the presence of a nearby object without any physical contact. The sensor component 1114 may also include a light sensor, such as a CMOS or CCD image sensor, for use in imaging applications. In some embodiments, the sensor component 1114 may also include an accelerometer sensor, a gyroscope sensor, a magnetic sensor, a pressure sensor, or a temperature sensor.

The communication component 1116 is configured to facilitate communication, wired or wirelessly, between the device 1100 and other devices. The device 1100 can access a wireless network based on a communication standard, such as WiFi, 2G, or 3G, or a combination thereof. In an exemplary embodiment, the communication component 1116 receives a broadcast signal or broadcast associated information from an external broadcast management system via a broadcast channel. In an exemplary embodiment, the communication component 1116 further includes a near field communication (NFC) module to facilitate short-range communications. For example, the NFC module may be implemented based on a radio frequency identification (RFID) technology, an infrared data association (IRDA) technology, an ultra-wideband (UWB) technology, a Bluetooth (BT) technology, and other technologies.

In exemplary embodiments, the device 1100 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 1104, executable by the processor 1118 in the device 1100, for performing the above-described methods. For example, the non-transitory computer-readable storage medium may be a ROM, a RAM, a CD-ROM, a magnetic tape, a floppy disc, an optical data storage device, and the like.

Other embodiments of the disclosure will be apparent to those skilled in the art from consideration of the specification and practice of the disclosures herein. This application is intended to cover any variations, uses, or adaptations of the disclosure following the general principles thereof and including such departures from the present disclosure as come within known or customary practice in the art. It is intended that the specification and examples be considered as exemplary only, with a true scope of the disclosure being indicated by the following claims.

It will be appreciated that the inventive concept is not limited to the exact construction that has been described above and illustrated in the accompanying drawings, and that various modifications and changes can be made without departing from the scope thereof. It is intended that the scope of the disclosure only be limited by the appended claims.

## Claims

1. A method, implemented by a device, for identifying face regions, **characterized in that** said method comprises:
obtaining (102) an area position of a face region in an identification image;
determining (104) at least one information region based on the area position of the face region; and
segmenting (106) the information region to get at least one character region.

2. The method of claim 1, wherein the area position of the face region is represented by using a predefined edge of the face region;
wherein said obtaining (102) an area position of a face region in an identification image comprises:
identifying (202) a face in the identification image to get the face region; and
identifying (204) the predefined edge of the face region based on the face region.

3. The method of claim 2, wherein said identifying (202) a face in the identification image to get the face region comprises:
identifying (202a) a face in a predefined region of the identification image to get the face region through a face model having a predefined face size.

4. The method of claim 2, wherein said identifying (204) the predefined edge of the face region based on the face region comprises:
determining (204a) a region of interest based on the lower part of the face region, wherein the region of interest comprises a lower edge of the face region; and
performing (204b) a straight line detection on the region of interest to identify the lower edge of the face region.

5. The method of claim 4, wherein said performing (204b) a straight line detection on the region of interest to identify the lower edge of the face region comprises:
subjecting (301) the region of interest to Sobel horizontal filter and binarization to obtain a processed region of interest; and
performing (302) a straight line fitting or a Hough transformation on the processed region of interest to get a line segment, of which the length is larger than a predefined length, and identify the line segment as the lower edge on the face region.

6. The method of any one of claims 2 to 5, further comprising:
correcting a lean of the identification image based on a slope of the predefined edge.

7. The method of claim 6, wherein said correcting a lean of the identification image based on a slope of the predefined edge comprises:
determining an angle between the predefined edge and a horizontal direction based on the slope of the predefined edge; and
rotating the identification image based on the angle so that the predefined edge of the rotated identification image is parallel to the horizontal direction.

8. The method of any one of claims 1 to 5, wherein said segmenting (106) the information region to get at least one character region comprises:
binarizing (208a) the information region to get a binarized information region;
calculating (208b) a first histogram for the binarized information region in the horizontal direction, wherein the first histogram comprises vertical coordinates of pixel points in each row and an accumulated value of the number of the pixel points of a foreground color in the pixel points in each row;
identifying (208c) *n* rows of character regions based on a set of consecutive rows composed of the rows in which the accumulated value of the numbers of the pixel points of the foreground color in the first histogram is greater than a first threshold, wherein *n* is a positive integer;
for the *i^{th}* row of the character regions, calculating (208d) a second histogram in a vertical direction, wherein the second histogram comprises horizontal coordinates of the pixel points in each column and an accumulated value of the numbers of the pixel points of the foreground color in the pixel points in each column, wherein *n* ≥ *i* ≥ 1 and *i* is a positive integer;
identifying (208e) *nᵢ* character regions based on a set of consecutive columns composed of the columns in which the accumulated value of the numbers of the pixel points of the foreground color in the second histogram is greater than a second threshold.

9. A device for identifying regions, **characterized in** comprising:
an obtaining module (610) configured to obtain an area position of a face region in an identification image;
a determination module (620) configured to determine at least one information region based on the area position of the face region; and
a segmentation module (630) configured to segment the information region to get at least one character region.

10. The device of claim 9, wherein the area position of the face region is represented by using a predefined edge of the face region;
wherein the obtaining module (610) comprises:
a first identification sub-module (611) configured to identify a face in the identification image to get the face region; and
a second identification sub-module (612) configured to identify the predefined edge of the face region based on the face region.

11. The device of claim 10, wherein the first identification sub-module (611) is configured to identify a face in a predefined region of the identification image to get the face region through a face model having a predefined face size.

12. The device of claim 10 or 11, wherein the second identification sub-module (612) comprises:
an interest determination sub-module (810) configured to determine a region of interest based on the lower part of the face region, wherein the region of interest comprises a lower edge of the face region; and
a detection sub-module (820) configured to perform a straight line detection on the region of interest to identify the lower edge of the face region.

13. The device of claim 12, wherein the detection sub-module (820) comprises:
a filter sub-module (821) configured to subject the region of interest to Sobel horizontal filter and binarization to obtain a processed region of interest; and
a transformation sub-module (822) configured to perform a straight line fitting or a Hough transformation on the processed region of interest to get a line segment, of which the length is larger than a predefined length, and identify the line segment as the lower edge on the face region.

14. The device of any one of claims 10 to 13, further comprising:
a correction module (910) configured to correct a lean of the identification image based on a slope of the predefined edge;
wherein the correction module (910) comprises:
an angle determination sub-module (911) configured to determine an angle between the predefined edge and the horizontal direction based on the slope of the predefined edge; and
a rotation sub-module (912) configured to rotate the identification image based on the angle so that the predefined edge of the rotated identification image is parallel to the horizontal direction.

15. The device of any one of claims 9 to 14, wherein the segmentation module (630) comprises:
a binarization module (631) configured to binarize the information region to get a binarized information region;
a first calculation sub-module (632) configured to calculate a first histogram for the binarized information region in the horizontal direction, wherein the first histogram comprises vertical coordinates of pixel points in each row and an accumulated value of the numbers of the pixel points of a foreground color in the pixel points in each row;
a row identification sub-module (633) configured to identify *n* rows of character regions based on a set of consecutive rows composed of the rows in which the accumulated value of the numbers of the pixel points of the foreground color in the first histogram is greater than a first threshold, wherein *n* is a positive integer;
a second calculation sub-module (634) configured to, for the *i^{th}* row of the character regions, calculate a second histogram in a vertical direction, wherein the second histogram comprises horizontal coordinates of the pixel points in each column and an accumulated value of the numbers of the pixel points of the foreground color in the pixel points in each column, wherein *n* ≥ *i ≥* 1 and *i* is a positive integer; and
a character identification sub-module (635) configured to identify *nᵢ* character regions based on a set of consecutive columns composed of the columns in which the accumulated value of the numbers of the pixel points of the foreground color in the second histogram is greater than a second threshold.
